(19) Europäisches Patentamt
European Patent Office
Office européen des brevets

(11) **EP 2 022 171 B1**

(12) **FASCICULE DE BREVET EUROPEEN**

(45) Date de publication et mention
de la délivrance du brevet:
**18.08.2010 Bulletin 2010/33**

(21) Numéro de dépôt: **07731953.1**

(22) Date de dépôt: **26.04.2007**

(51) Int Cl.:
***H03K 5/13*** *(2006.01)*

(86) Numéro de dépôt international:
**PCT/FR2007/051180**

(87) Numéro de publication internationale:
**WO 2007/138202 (06.12.2007 Gazette 2007/49)**

(54) **PROCÉDÉ ET DISPOSITIF DE GÉNÉRATION DE SIGNAUX BINAIRES DÉPHASÉS ET LEUR UTILISATION**

VERFAHREN UND EINRICHTUNG ZUR ERZEUGUNG VON AUSSERPHASEN-BINÄRSIGNALEN UND VERWENDUNG DAFÜR

METHOD AND DEVICE FOR THE GENERATION OF OUT-OF-PHASE BINARY SIGNALS, AND USE OF THE SAME

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **31.05.2006 FR 0651965**

(43) Date de publication de la demande:
**11.02.2009 Bulletin 2009/07**

(73) Titulaire: **VALEO EQUIPEMENTS ELECTRIQUES MOTEUR**
**94046 Créteil Cedex (FR)**

(72) Inventeur: **ROUIS, Oussama**
**F-92300 Levallois Perret (FR)**

(56) Documents cités:
**DE-A1- 3 933 987      DE-A1- 4 128 909**
**US-A- 5 144 929**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE DE L'INVENTION.**

La présente invention concerne un procédé et un dispositif de génération de signaux binaires ayant un déphasage réglable basés sur un composant programmable.

**ARRIERE PLAN TECHNOLOGIQUE DE L'INVENTION.**

Les circuits déphaseurs sont utilisés dans de nombreuses applications de l'électronique, tant en traitement du signal qu'en électronique de puissance. En général, un circuit est conçu pour réaliser un déphasage donné à une fréquence donnée. Le circuit doit être modifié pour un autre angle de phase, ou une autre fréquence.

Les circuits et les procédés décrits dans le document US6744296 ont changé cette situation, puisque l'angle de déphasage peut être continûment réglé par une tension indépendamment de la fréquence.

Cependant les composants analogiques utilisés en partie dans les circuits précédents ne garantissent pas la génération de déphasages très précis requise par certaines applications.

C'est le cas notamment dans des applications à l'automobile, comme les allumages électroniques decrit par exemple dans le document DE 41 28 909 A1, ou le pilotage des moteurs/générateurs électriques sans balais.

Le document US4788957, par exemple, propose donc d'améliorer les dispositifs de contrôle du point d'allumage des moteurs à combustion interne en mettant en oeuvre un circuit de déphasage et un détecteur d'autoallumage constitués par un ordinateur.

Un obstacle à la généralisation des méthodes entièrement numériques dans le domaine, bien qu'elles soient très avantageuses au plan de la souplesse d'implémentation et des coûts, par rapport aux procédés analogiques, a été la grande puissance de calcul nécessaire pour suivre les variations rapides des signaux.

L'apparition sur le marché des composants de microcontrôleurs multiprocesseurs permet de lever cette contrainte, à condition qu'ils soient programmés de façon appropriée.

Le document US5317248 divulgue précisément une façon de programmer un microcontrôleur MC68332 de la société MOTOROLA pour générer les impulsions de commande, modulées en largeur, de machines électriques polyphasées.

Le microcontrôleur MC68332 possède en plus d'une unité centrale de traitement, ou CPU (CPU est l'acronyme anglais de Central Processing Unit), une unité de calcul dédiée aux événements temporels, ou TPU (TPU est l'acronyme anglais de Time Processor Unit). La TPU possède des circuits retardateurs programmables (connus par l'homme de métier sous le vocable anglais « timer ») et des module de modulation de largeur d'impulsions programmables, dits modules PWM (PWM est l'acronyme anglais de Pulse Width Modulation).

La TPU génère un signal de synchronisation et des impulsions centrées sur les fronts de ce signal.

Les algorithmes décrits dans le document US5317248 cherchent à limiter les délais de transit et la gigue, mais la méthode utilisée ne semble applicable que dans le cas où les signaux générés ne sont déphasés que par rapport à un seul signal de synchronisation, issu d'un seul capteur de position du rotor de la machine.

Or, on sait qu'il est préférable qu'une machine électrique polyphasée comporte un capteur de position pour chaque phase afin de détecter rapidement les variations de vitesse du rotor.

**DESCRIPTION GENERALE DE L'INVENTION.**

La présente invention vise donc à combler cette lacune en fournissant un procédé de génération de signaux binaires déphasés par rapport à au moins un signal binaire de synchronisation d'un ensemble de signaux binaires de synchronisation. L'angle de déphasage de contrôle est continûment variable, et les signaux de synchronisation ont une même période variable.

Ce procédé est du type de ceux consistant à élaborer les fronts montants et descendants des signaux déphasés en calculant au moins un délai de commutation de niveau à partir de fronts de synchronisation, montants ou descendants, du signal binaire de synchronisation au moins, en fonction au moins de l'angle de déphasage de contrôle.

Le procédé selon l'invention est remarquable en ce qu'au moins un front de référence est choisi parmi les fronts de synchronisation tel que ce délai de commutation de niveau est minimum.

De préférence, le nombre des signaux déphasés et le nombre des signaux de synchronisation sont égaux à un nombre de phases prédéterminé. Les signaux de synchronisation ont avantageusement un rapport cyclique égal à 0,5 et sont déphasés entre eux d'un angle de déphasage nominal en degrés égal à 360° divisé par ce nombre de phases. Une caractéristique additionnelle du procédé selon l'invention consiste alors à mesurer un intervalle de temps compris entre deux fronts de synchronisation successifs, l'un étant montant et l'autre descendant.

Le délai de commutation de niveau est calculé pour un signal binaire de synchronisation courant parmi les signaux binaires de synchronisation, en vue d'élaborer le front correspondant du signal binaire déphasé courant associé, de préférence par l'expression suivante :

$$\Delta T1 = \Delta Tpn \ * \ (\Delta \varphi ref - \varphi + 180) \ * \ Np/360$$

où :

- $\Delta Tpn$ est l'intervalle de temps mesuré précédemment;
- $\varphi$ est l'angle de phase de contrôle exprimé en degré ;
- $\Delta \varphi ref$ est le déphasage $\varphi 0$ - $\varphi r$, exprimé en degrés, entre un front initial d'angle de phase initial $\varphi 0$ du signal binaire de synchronisation courant et le front de référence d'angle de phase de référence $\varphi r$ d'un signal binaire de synchronisation de référence choisi parmi les signaux de synchronisation;
- $Np$ est égal au double du nombre de phases.

On tire bénéfice du fait qu'une valeur interfront de l'intervalle de temps compris entre deux fronts de synchronisation successifs, résulte d'un comptage au moyen d'un circuit retardateur programmable de mesure, ayant une fréquence d'incrémentation de mesure prédéterminée, qui est associé aux signaux binaires de synchronisation.

Dans ce cas, une valeur courante du délai de commutation de niveau est calculée pour un signal binaire de synchronisation courant parmi les signaux binaires de synchronisation, en vue d'élaborer le front correspondant du signal binaire déphasé courant associé, préférentiellement par l'expression suivante :

$$V\Delta T1 = V\Delta Tpn \ * \ (\Delta \varphi ref - \varphi + 180) \ * \ Np/360$$

où :

- $V\Delta Tpn$ est la valeur interfront;
- $\varphi$ est l'angle de phase de contrôle exprimé en degré ;
- $\Delta \varphi ref$ est le déphasage $\varphi 0$ - $\varphi r$, exprimé en degrés, entre un front initial d'angle de phase initial $\varphi 0$ du signal binaire de synchronisation courant et le front de référence d'angle de phase de référence $\varphi r$ d'un signal binaire de synchronisation de référence choisi parmi les signaux binaires de synchronisation ;
- $Np$ est égal au double du nombre de phases.

A ce stade, le procédé de génération de signaux binaires déphasés selon l'invention comprend fort avantageusement les étapes suivantes :

- on rend la fréquence d'incrémentation courante d'un circuit retardateur programmable courant associé au signal binaire de synchronisation courant égale à la fréquence d'incrémentation de mesure;
- on associe une ligne de sortie courante au circuit retardateur programmable courant ;
- on charge la valeur courante $V\Delta T1$ du délai de commutation dans le circuit retardateur programmable courant;
- on configure ce circuit retardateur programmable courant de manière que la ligne de sortie courante effectue

une première transition d'un niveau haut vers un niveau bas, ou bien une seconde transition d'un niveau bas vers un niveau haut, quand un compteur courant du retardateur programmable courant atteint la valeur courante $V\Delta T1$ ;

- on génère le signal binaire déphasé courant au moyen de la ligne de sortie courante.

Alternativement aux étapes précédentes, le procédé de génération de signaux binaires déphasés selon l'invention comprend aussi avantageusement en variante les étapes suivantes :

- on rend la fréquence d'incrémentation courante d'un circuit retardateur programmable courant associé au signal binaire de synchronisation courant égale à la fréquence d'incrémentation de mesure;
- on charge la valeur courante $V\Delta T1$ du délai de commutation dans le circuit retardateur programmable courant ;
- on active une interruption courante associée au circuit retardateur programmable courant se produisant à chaque fois que la valeur courante $V\Delta T1$ est atteinte ;

- on rend la fréquence de comptage courante d'un compteur programmable courant d'un module de modulation de largeur d'impulsions programmable courant égale à la fréquence d'incrémentation de mesure divisée par le double du nombre de phases;
- on associe une ligne de sortie courante au module de modulation de largeur d'impulsions programmable courant;
- on charge un registre de période courant et un registre de rapport cyclique courant du module de modulation de largeur d'impulsions programmable courant respectivement avec la valeur interfront $V\Delta Tpn$ et avec la moitié de cette valeur ;
- on configure le module de modulation de largeur d'impulsions programmable courant de façon que la ligne de sortie courante subisse une transition initiale d'un niveau haut à un niveau bas, puis une première transition d'un niveau bas à un niveau haut quand le compteur programmable

courant atteint une valeur intermédiaire courante contenue dans le registre de rapport cyclique courant, et enfin une seconde transition d'un niveau haut à un niveau bas quand le compteur programmable courant atteint une valeur finale courante contenue dans le registre de période courant à chaque déclenchement de l'interruption courante;

- on génère le signal binaire déphasé courant au moyen de la ligne de sortie courante.

L'invention concerne aussi un dispositif de génération de signaux binaires déphasés d'un angle de déphasage de contrôle continûment variable par rapport à au moins un signal binaire de synchronisation d'un ensemble de signaux binaires de synchronisation, du type de ceux comportant un microprocesseur ou un microcontrôleur comprenant:

- au moins une unité centrale de traitement;
- au moins une mémoire volatile et/ou au moins une mémoire non-volatile;
- au moins un circuit retardateur programmable;
- au moins un port d'entrée;

Les mémoires de ce dispositif se distinguent de l'état de la technique par le fait qu'elles contiennent un programme mettant en oeuvre le procédé selon l'invention.

En variante, le dispositif comprend aussi de préférence au moins module de modulation de largeur d'impulsions programmable.

Le dispositif comporte de plus avantageusement une interface série recevant un signal représentatif de l'angle de phase de contrôle. Cette interface assure de préférence une liaison avec un réseau embarqué de type CAN.

On retira bénéfice de l'utilisation du procédé et/ou du dispositif selon l'invention dans la boucle de contrôle d'une machine électrique polyphasée embarquée sur un véhicule, notamment automobile.

Il va de soi que l'invention concerne également les séquences d'instructions exécutables par le dispositif décrit ci-dessus et mettant en oeuvre le procédé exposé précédemment.

Ces quelques spécifications essentielles auront rendu évidents pour l'homme de métier les avantages apportés par le procédé et le dispositif de génération de signaux déphasés, selon l'invention, par rapport à l'état de la technique antérieur.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

## BREVE DESCRIPTION DES DESSINS.

La Figure 1 montrent des chronogrammes de signaux binaires de synchronisation et de signaux binaires déphasés, dans le cas où le nombre phases est égal à trois.

La Figure 2 illustre le principe de l'évaluation de la valeur interfront $V\Delta Tpn$ au moyen d'un circuit retardateur programmable de mesure.

Les Figures 3a, 3b et 3c montrent des exemples de déphasage $\Delta\varphi ref$ entre un front initial d'un signal binaire de synchronisation courant et un front de référence d'un signal binaire de synchronisation de référence.

La Figure 4 illustre les détails du procédé selon l'invention en cas de croissance de la fréquence des signaux de synchronisation.

La Figure 5 montre la programmation des fronts des signaux déphasés en fonction du complément à 180° de l'angle de déphasage de contrôle.

La Figure 6 montre la concaténation des niveaux sur la ligne de sortie d'un circuit retardateur programmable pour générer un signal binaire déphasé en fonction de l'angle de déphasage de contrôle.

Les Figures 7, 8 et 9 illustrent une variante du procédé selon l'invention mettant en oeuvre un module PWM.

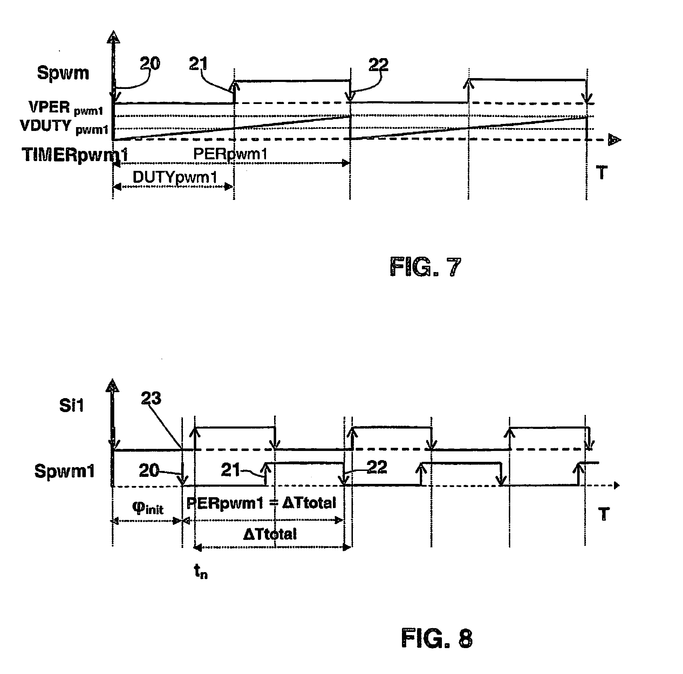

La Figure 7 montre le principe de la génération d'un signal binaire au moyen d'un compteur programmable de ce module.

La Figure 8 montre le principe de la génération d'un signal binaire déphasé par rapport à un signal binaire de synchronisation.

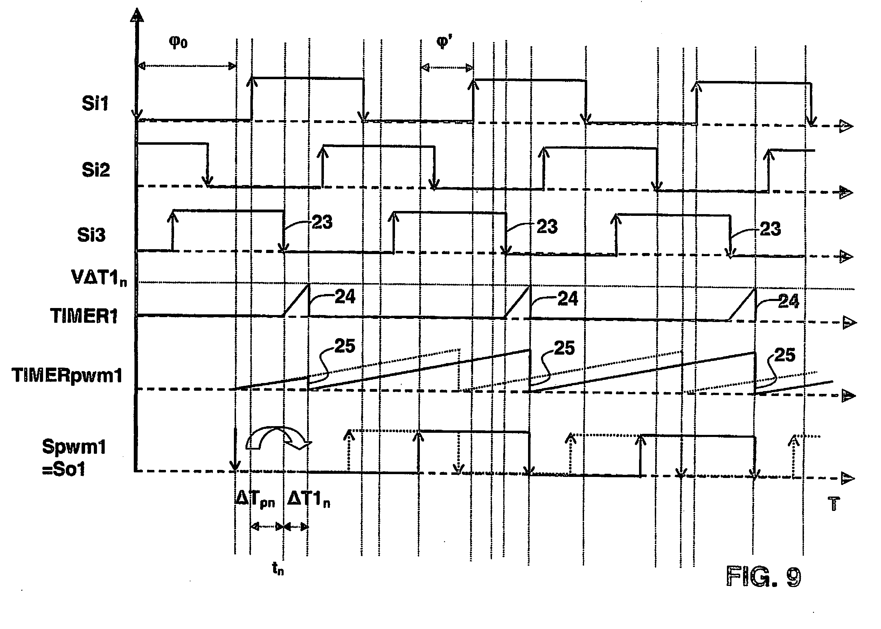

La Figure 9 illustre la reconstruction d'un signal binaire déphasé courant à partir de trois signaux de synchronisation.

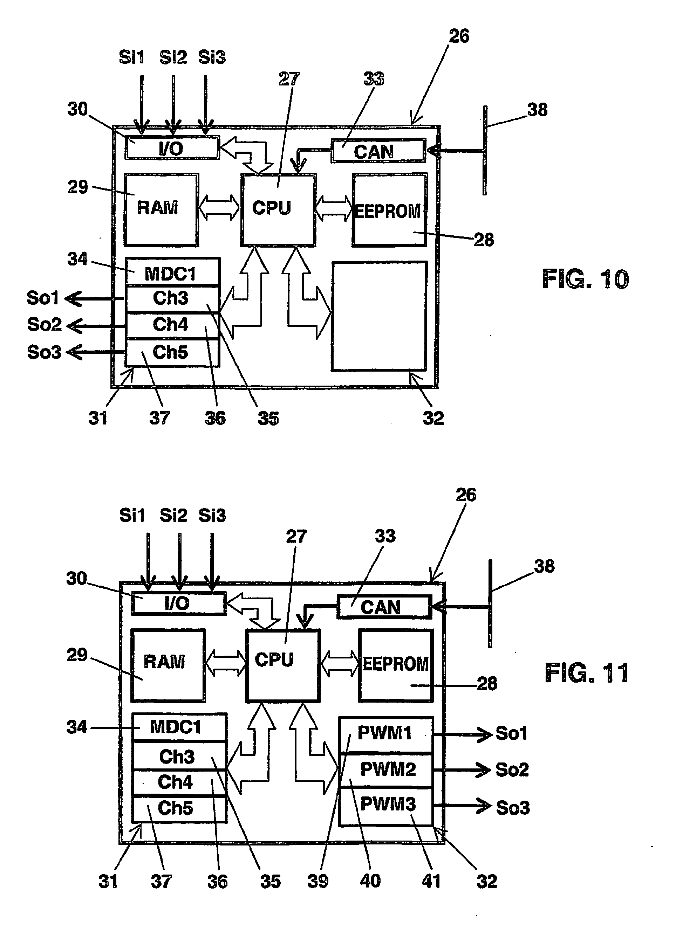

Les Figures 10 et 11 montrent l'architecture d'un microcontrôleur adapté à la mise en oeuvre du procédé selon l'invention.

**DESCRIPTION DES MODES DE REALISATION PREFERES DE L'INVENTION.**

Le procédé selon l'invention permet de régénérer à partir d'un nombre N de signaux en entrée, déphasés entre eux d'un angle de déphasage nominal Φ constant, le même nombre de signaux présentant le même déphasage Φ entre eux, mais avec un décalage programmable φ par rapport aux signaux d'entrée.

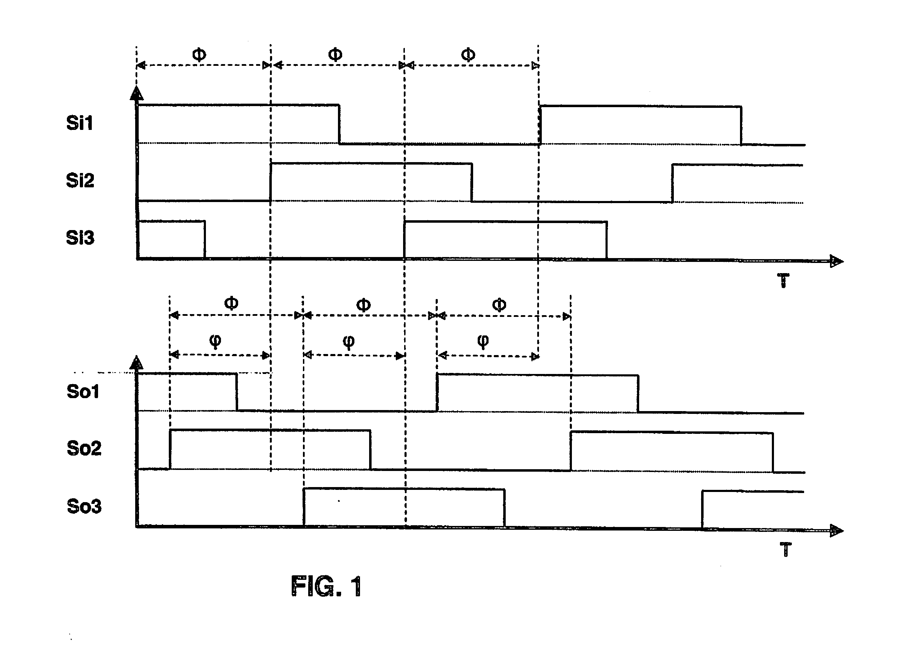

La Figure 1 illustre le cas où N=3. Les signaux d'entrée Si1,Si2,Si3 sont par exemple des signaux binaires de synchronisation issus des trois capteurs de la position du rotor d'une machine électrique triphasée. Ces signaux Si1,Si2,Si3 ont la même fréquence, présente un rapport cyclique de 0,5, et sont déphasés entre eux de Φ =120°.

Les trois signaux binaires déphasés So1,So2,So3 ont la même fréquence et le même rapport cyclique que les signaux de synchronisation Si1,Si2,Si3, ils présentent entre eux un déphasage Φ =120°, mais il existe un déphasage φ entre Si1 et So1, Si2 et So2, Si3 et So3.

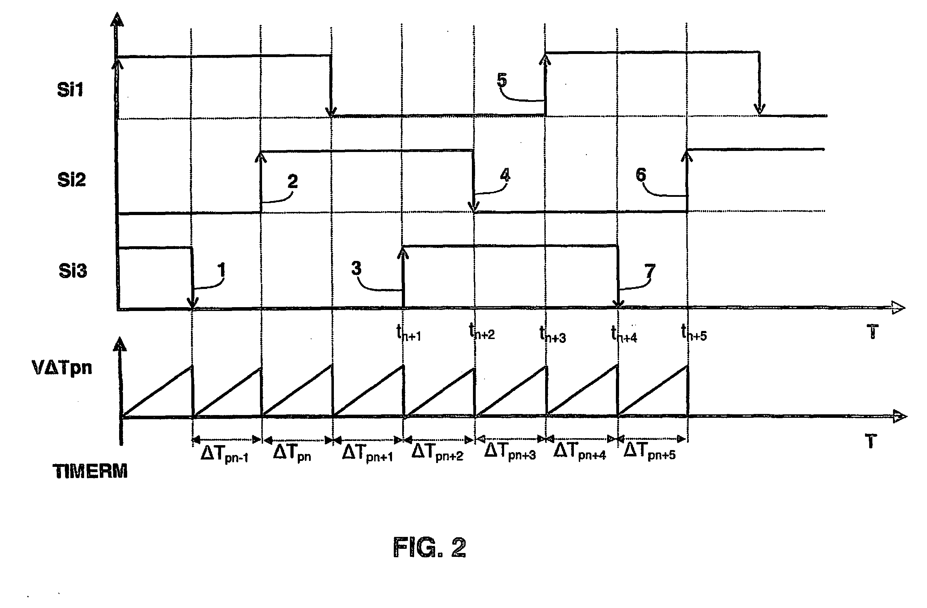

La régénération des signaux décalés se base sur deux sous-fonctions combinées : la reconstruction et le décalage. Les détails de ces deux sous-fonctions sont donnés ci-dessous en liaison avec les Figures 2 à 6 lorsque la régénération met en oeuvre des circuits retardateurs programmables, et en complément, avec les Figures 7,8 et 9 quand la régénération utilise des modules PWM.

La reconstruction des signaux binaires déphasés So1,So2,So3 passe par la mesure précise de la période des signaux binaires de synchronisation Si1,Si2,Si3.

Pour ce faire, en tenant compte du fait que l'on se restreint de préférence à N signaux d'entrée ayant un rapport cyclique de 0,5, et qui sont déphasés entre eux d'un angle de phase nominal Φ =360/N, il suffit de mesurer un intervalle de temps ΔTpn entre deux fronts successifs, descendant puis ascendant 1,2 ;4,5 ;7,6, ou ascendant puis descendant 3,4, par un circuit retardateur programmable TIMERM dont la fréquence d'incrémentation de mesure FTIMERM est prédéterminée, comme le montre la Figure 2.

La valeur en unité de temps du timer de l'intervalle de temps ΔTpn, c'est-à-dire le résultat VΔTp du comptage par le timer TIMERM est :

$$V\Delta Tpn = \Delta Tpn * FTIMER$$

La période ΔTtotal des signaux de synchronisation Si1,Si2,Si3 est alors à l'instant tn:

$$\Delta Ttotal = Np * \Delta Tpn$$

ou, dans l'unité de temps du timer TIMERM:

$$V\Delta Ttotal = Np * V\Delta Tpn$$

Np étant le nombre de fronts par période électrique des signaux Si1,Si2,Si3, c'est-à-dire Np=2*N.

Cette valeur chargée dans le registre d'un circuit retardateur programmable associé à chacun des signaux déphasés So1,So2,So3 permettrait de manière connue de régénérer des impulsions ayant une période identique à celle des signaux de synchronisation Si1,Si2,Si3 en entrée.

Mais cette méthode élémentaire n'est pas utilisée, car elle conduirait à des délais de transit importants, et à une forte gigue, qui limiteraient l'application du procédé à des signaux de synchronisation Si1,Si2,Si3 de fréquence basse.

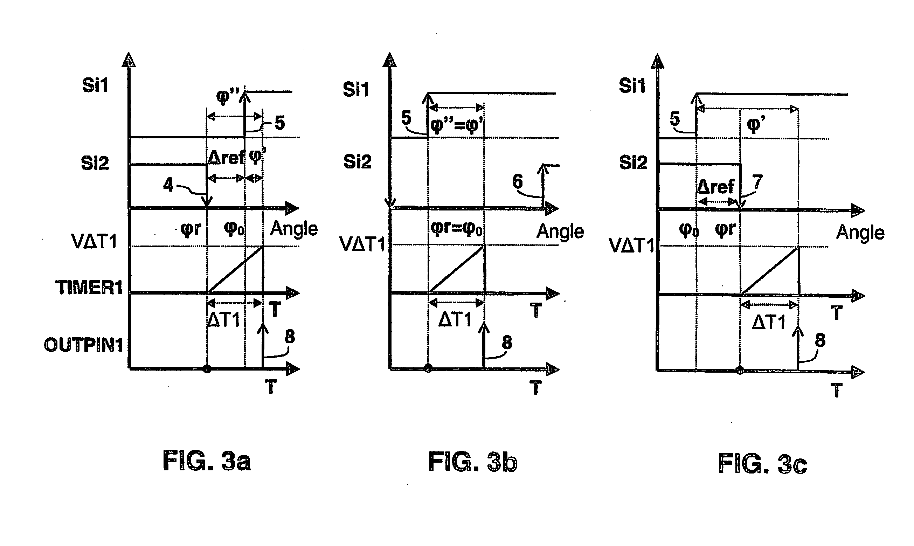

Seule la valeur interfront VΔTpn à l'instant tn est utilisée pour élaborer les fronts montants et descendants des signaux binaires déphasés So1,So2,So3, en tenant compte de plus de la consigne de déphasage φ, ainsi qu'il est expliqué ci-dessous en liaison avec les Figures 3a,3b et 3c.

Avec le signal de synchronisation Si1 est associé un circuit retardateur programmable TIMER1 ayant les caractéristiques suivantes :

- le circuit retardateur TIMER1 est adjoint à une ligne de sortie physique OUTPIN1 en mode « output compare » (C'est-à-dire que le circuit compare en permanence la valeur de son comptage à une valeur de référence, et en fonction du résultat exécute une instruction préprogrammée) ;
- le niveau de la future transition H->L ou L->H après un délai $\Delta$T1 est programmée (par convention H désigne un niveau logique haut, et L un niveau logique bas, initiales de « high » et « low » en anglais);
- il est possible de forcer la transition à tout moment avant la fin de la période programmée.

La même description s'applique aux circuits retardateurs programmables associés aux autres signaux de synchronisation Si2,Si3 . (On conviendra dans ce qui suit que les références aux signaux Si1, ou So1, s'appliquent à un signal binaire de synchronisation « courant », ou un signal binaire déphasé « courant », c'est-à-dire, respectivement, l'un quelconque des signaux binaires de synchronisation Si1,Si2,Si3, ou des signaux binaires déphasés So1,So2,So3).

Cette configuration permet d'éviter l'utilisation des interruptions et donc optimise la charge CPU, car les transitions de niveaux sur TIMER1 seront gérées par le composant à la fin de la période programmée.

Alternativement, selon les besoins, le circuit retardateur programmable TIMER1 est configuré en mode « interruption ».

Dans ce dernier mode de fonctionnement, l'interruption associée au TIMER1 appelle une routine d'interruption après une délai $\Delta$T1 : la transition de niveau H->L ou L->H se fait alors d'une façon directe par accès au registre d'état de la ligne de sortie OUTPIN1 associée à TIMER1. L'accès direct à OUTPIN1 est possible à tout moment pour forcer le niveau désiré.

Le mode de fonctionnement du timer courant TIMER1 ayant été programmé, on configure sa base de temps de telle sorte que la fréquence d'incrémentation courante FTIMER1 soit égale à la fréquence d'incrémentation de mesure FTIMERM du timer TIMERM utilisé pour la mesure de la période des signaux Si1,Si2,Si3

La génération du signal binaire déphasé So1 passe par les étapes suivantes :

- on acquière la valeur interfront V$\Delta$Tpn à l'instant tn ; .
- on considère une échelle de 0° à 360° représentant le retard $\varphi$' entre Si1 et le signal à créer So1 telle que $\varphi$' = 180° - $\varphi$ ;
- pour chaque front 1-7 de Si1, Si2 et Si3 on calcule V$\Delta$T1, la valeur à charger dans TIMER1 pour créer un retard $\Delta$T1 en fonction de $\Delta$Tpn et du retard $\varphi$' ;
- au moyen de macro-instructions CLEAR_NEXT_T1 ou SET_NEXT_T1, on configure le timer TIMER1 pour une transition d'un niveau haut vers un niveau bas, ou pour une transition d'un niveau bas vers un niveau haut respectivement.

La transition se produit lorsque le compteur TIMER1 atteint la valeur courante V$\Delta$T1 chargée dans son registre de comparaison. La valeur courante V$\Delta$T1 correspond au délai $\Delta$T1 à produire par rapport au front de référence et $\Delta\varphi$ref est la différence d'angle de phase entre le front initial 5 d'angle de phase initial $\varphi_0$ et les fronts de référence 4,5,7 d'angle de phase de référence $\varphi$r.

La valeur courante V$\Delta$T1 du délai $\Delta$T1est calculée de la façon suivante :

$$\Delta\varphi ref \ = \ \varphi_0 \ - \ \varphi r$$

$$\varphi' = 180 \ - \ \varphi$$

$$\varphi'' \ = \ \varphi' \ + \ \Delta\varphi ref$$

$$V\Delta T1 \ = \ V\Delta Tpn \ * \ ((\varphi'' \ * \ N_r) \ / \ 360)$$

Les figures 3a, 3b et 3c montrent un exemple de calcul de trois valeurs de $\Delta\varphi$ref pour trois fourchettes de

valeurs de φ' (Le front initial pour le signal Si1 est prix à φ0 = 0).

Dans chaque cas de figure, le front de référence 4,5,7 choisi parmi les fronts 1-7 de l'ensemble des signaux de synchronisation Si1,Si2,Si3. précédents le front à reconstruire 8 du signal binaire déphasé So1 est le front le plus proche 4,5,7, de la transition à obtenir 8, c'est-à-dire celui pour lequel le délai de commutation de niveau VΔT1 est minimum.

La Figure 3a montre que pour 0°< φ' < 30°, le front de référence 4 est pris sur le front descendant 4 de Si2. Dans ce cas:

$$\Delta\text{ref} \;=\; 0 \;-\; (-60) \;=\; 60°$$

et

$$V\Delta T1 \;=\; (V\Delta Tpn \;*\; (\varphi' \;+\; 60))/60$$

La Fig 3b montre que pour 90° > φ' ≥ 30° le front de référence 5 et le front initial 5 sont confondus avec le front ascendant 5 de Si1. Dans ce cas :

$$\Delta\text{ref} \;=\; 0 \;\text{ et } V\Delta T1 \;=\; (V\Delta Tpn \;*\; \varphi')/60$$

La Fig 3c montre que pour 150° > φ' ≥ 90° le front de référence 7 est pris sur le front descendant de Si3. Dans ce cas :

$$\Delta\text{ref} \;=\; 0 \;-\; 60 \;=\; -\; 60°$$

et

$$V\Delta T1 \;=\; (V\Delta Tpn \;*\; (\varphi' \;-\; 60))/60$$

De manière générale, les fronts de référence 4,5,7 sont choisis en fonction de φ' de façon à avoir le minimum de retard entre l'instant tn ou la mesure ΔTpn est disponible et l'apparition du front programmé sur la ligne de sortie OUTPIN1.

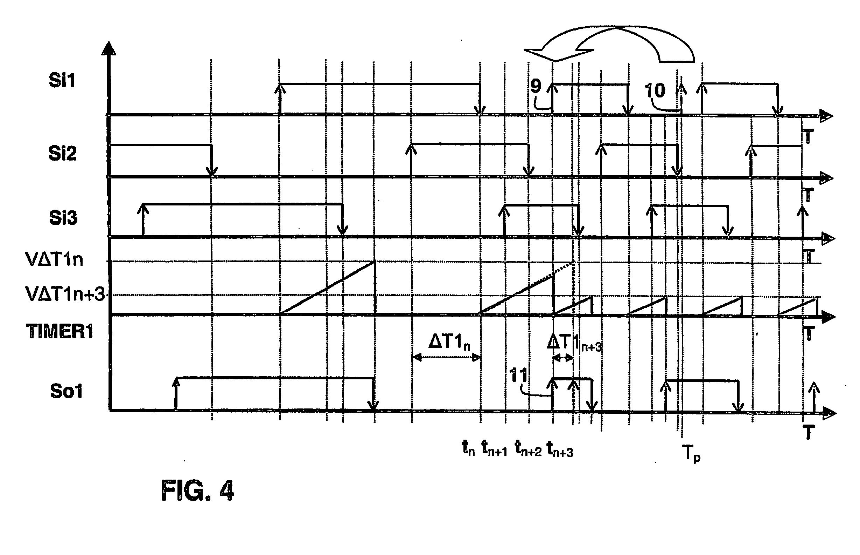

Lorsque la fréquence des signaux Si1, Si2 et Si3 en entrée croît, la période ΔTpn mesurée décroît, le front 9 suivant de Si1, Si2 ou Si3 peut alors tomber avant le front 10 prévu à l'instant Tp et avant la fin de le délai VΔT1 déjà programmé comme le montre la Figure 4.

Dans tous les cas, toute transition programmée à un instant ΔTpnest systématiquement forcée à l'instant ΔTpn+1.

La Figure 4 montre bien que le front ascendant 9 de Si1 est survenu à l'instant tn+3 avant l'instant Tp prévu et avant la fin du délai VΔT1n mesuré à l'instant tn+3 et programmé dans le timer TIMER1. La macro-instruction FORCE_TIMER1 permet de forcer la transition 11 déjà programmée à l'instant tn avant de recalculer la nouvelle valeur VΔT1n+3 qui tiendra compte de la nouvelle valeur de la fréquence.

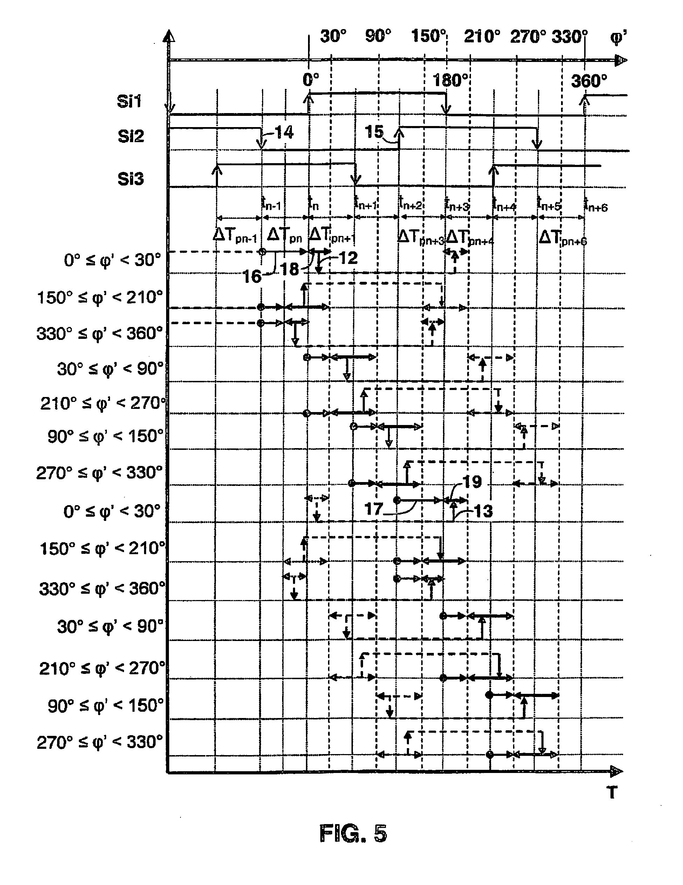

La Figure 5 détaille les étapes, selon l'invention, de la construction du signal So1 sur chaque front de Si1, Si2 et Si3 en fonction de φ'.

Par convention, sur cette figure, notamment sur les chronogrammes établis dans le cas où l'angle de déphasage φ' est compris entre 0° et 30°, un front programmé est symbolisé par un vecteur 12,13, son rattachement au front de référence 14,15 est symbolisé par un autre vecteur 16,17 dont l'origine est marquée par un point, et sa latitude de variation est représentée par une double flèche en trait gras 18,19.

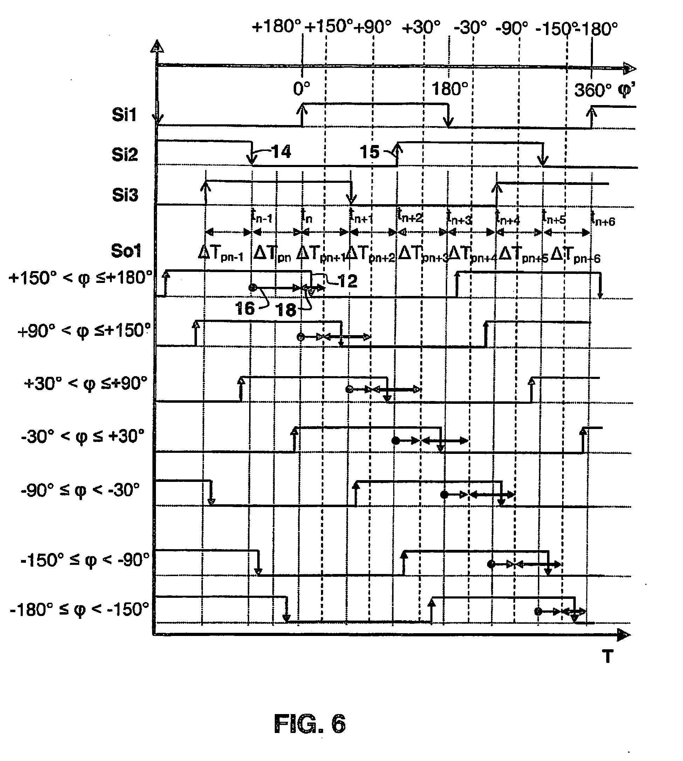

La concaténation des niveaux permet l'obtention d'un signal So1 image de Si1 décalé de φ comme le montre la Figure 6 (La convention de représentation des fronts est la même que sur la Figure 5).

Le procédé selon l'invention appliqué à Si1, Si2 et Si3 pour obtenir So1 est utilisé pour la génération des deux signaux So2 et So3:

- Si2, Si3 et Si1 sont respectivement utilisés pour régénérer So2;
- Si3 et Si1 et Si2 sont respectivement utilisés pour régénérer So3.

Selon une variante du procédé selon l'invention, la sous-fonction de reconstruction des signaux binaires déphasés So1, So2 et So3 est assurée par des modules PWM au lieu de l'être uniquement par la programmation de circuits retardateurs programmables TIMER1

Dans les paragraphes qui suivent, on décrit les étapes par lesquelles passe la reconstruction du signal So1 en faisant référence aux Figures 7,8 et 9, (les mêmes étapes seront adoptées pour générer So2 et So3) :

- on configure le périphérique PWM pour qu'il génère un signal Spwm1 tel que représenté schématiquement sur la Figure 7, avec un front de départ 20 descendant ;
- la base de temps pour le compteur programmable interne TIMERPWM1 du module PWM est configurée de manière que:

$$FPWM = FTIMERM \ / \ N_{P}$$

FPWM étant la fréquence de comptage en Hz du compteur TIMERpwm1 et FTIMERM étant la fréquence d'incrémentation de mesure en Hz du circuit retardateur de mesure TIMERM utilisé pour la mesure de l'intervalle de temps $\Delta Tpn$ ;
- le compteur TIMERPWM1 compte de 0 à la valeur intermédiaire VDUTYpwm1 programmée dans le registre du rapport cyclique REGDUTYpwm1 , et lorsqu'il atteint cette valeur, le signal Spwm1 change d'état en produisant un front montant 21 ;
- lorsque le compteur atteint la valeur finale VPERpwm1 programmée dans le registre de configuration de la période REGPERpwm1, le signal Spmw1 change à nouveau d'état en produisant un front descendant 22 ;
- on acquière V$\Delta$Tpn à l'instant tn, la dernière valeur interfront disponible sur chaque front des signaux Si1, Si2 ou Si3, on reconfigure les registres du module PWM tel que :

$$REGPERpwm1 = V\Delta Tpn$$

$$REGDUTYpwm1 = V\Delta Tpn/2$$

Comme le montre la Figure 8, le résultat est un signal Spwm1 qui présente la même période PERpwm1, et le même rapport cyclique que Si1, mais qui est déphasé d'un angle φinit qui dépend de l'instant 23 d'activation du module PWM.

La sous-fonction de reconstruction de So1 étant réalisée au moyen du module PWM dans cette variante, la détermination du décalage du signal Spwm1 est effectuée comme dans le procédé de base.

Pour chaque front de Si1, Si2 et Si3, on calcule la valeur courante V$\Delta$T1=V$\Delta$Tpn * (($\varphi$" * N) / 360) que l'on charge dans le registre du circuit retardateur TIMER1 pour créer un délai de commutation de niveau $\Delta$T1 en fonction de l'intervalle de temps $\Delta$Tpn et de l'angle de déphasage de contrôle $\varphi$.

L'interruption INT1 associée au timer TIMER1, qui se produit à chaque fois que le comptage atteint la valeur V$\Delta$T1 chargée dans son registre de comparaison, déclenche l'appel de la routine de reconstruction par le module PWM , qui :

- désactive l'interruption INT1 associée au TIMER1 ;
- remet à 0 la valeur du compteur TIMERpwm1 ;
- génère une période PERpwm1 du signal binaire déphasé So1 ;
- acquitte l'interruption INT1 pour une future activation.

La Figure 9 montre bien la séquence des opérations effectuées pour régénérer le signal binaire Si1 en reconstruisant et en décalant le signal Spwm1.

Au bout de la valeur courante V$\Delta$T1 du délai de commutation $\Delta$T1 calculé à partir du front de référence 23 approprié choisi sur Si3, le circuit retardateur TIMER1 associé à Si1 s'arrête 24. L'interruption INT1 générée par cet évènement déclenche au même instant la reconstruction du signal Spwm1.

Le procédé selon l'invention a été implémenté sur une cible microcontrôleur 16 bits MC9S12DG128 fabriqué par la société Motorola.

Il s'agit d'un composant 26 dont l'architecture générale est représentée sur les Figures 10 et 11. Il comprend:

- une unité centrale de traitement 27, dont la fréquence de l'horloge interne Fbus du bus interne est de préférence de 20Mhz ;
- une mémoire non volatile 28 de type « flash », de préférence de 128Koctets ;
- une mémoire RAM 29, ayant de préférence une capacité de 8Koctets (RAM est l'acronyme anglais de « Random Access Memory », c'est-à-dire « Mémoire à Accès Aléatoire ») ;
- un port I/O 30, dont les entrées sont susceptibles de déclencher des interruptions sur fronts montant ou descendant, ou les deux, selon leur configuration (I/O désigne des Entrées/Sorties, Input/Output en anglais);
- un périphérique ECT 31 (ECT est l'acronyme anglais de « Enhanced Capture Timer », c'est-à-dire « Compteur d'Acquisition Amélioré ») ;
- un périphérique PWM 32;
- une interface CAN 33 (CAN est l'acronyme anglais de « Controller Area Network », c'est-à-dire « Réseau Local de Contrôleurs ») ;
- une interface JTAG (JTAG est l'acronyme anglais de « Join Test Action Group », c'est-à-dire « Groupe d'Action pour les Tests Commun ») pour la programmation et le débogage selon le standard IEEE1149.1.

Dans le procédé selon l'invention de base, comme dans sa variante, la détermination de la valeur interfront V$\Delta$Tpn est assurée par un décompteur 34 auxiliaire MDC1 (MODULUS DOWN-COUNTER) disponible dans le module ECT et utilisé en association avec les entrées de Si1, Si2 et Si3.

A cet effet, on configure le prédiviseur associé à MDC1 pour avoir une fréquence de décomptage FprédMDC1 égale à celle FprédPC1 du compteur principal du module ECT 31.

Sur chaque front ascendant ou descendant de Si1, Si2 ou Si3, une interruption est générée. La différence entre la valeur maximale 0xFFFF et la valeur instantanée du décompteur MDC1 est sauvegardée dans une variable V$\Delta$Tpn avant de remettre le décompteur MDC1 de nouveau à 0xFFFF.

L'implémentation des étapes suivantes du procédé selon l'invention dans sa version de base, repose sur l'utilisation du compteur principal PC1 sur 16bits du périphérique ECT, et sur un prédiviseur en amont pour la configuration de la fréquence d'incrémentation dérivé de la fréquence horloge.

Les trois canaux Ch3, Ch4 et Ch5 35,36,37 du compteur principal PC1 sont utilisés pour la reconstruction respective des signaux So1, So2 et So3. La configuration suivante est adoptée :

- le prédiviseur de PC1 est configuré pour avoir à sa sortie une fréquence FprédPC1= Fbus/16 , soit de préférence 1.25MHz ;
- Ch3, Ch4 et Ch5 sont configurés en mode « output compare" avec interruptions désactivées ;
- la macro-instruction CLEAR_NEXT_OUTPUT_Tn configure une future transition descendante sur la sortie (n) ;
- la macro-instruction SET_NEXT_OUTPUT_Tn configure une future transition ascendante sur la sortie (n) ;
- la macro-instruction FORCE_COMPARE_Tn est utilisée pour forcer une transition asynchrone ascendante ou descendante sur une sortie (n) avant l'échéance de la période initialement programmée.

Sur chaque front ascendant ou descendant de Si1, Si2 ou Si3 une interruption est générée. Le signal à l'origine de l'interruption (Sin parmi Si1, Si2 et Si3) et la nature de la transition (ascendante ou descendante) étant identifiés par la lecture de l'état des entrées associées, on calcule en fonction de la consigne de décalage φ la valeur V$\Delta$Tn comme décrit précédemment.

En fonction de Sin et de la nature de la transition, la valeur V$\Delta$Tn est affectée au registre TCn correspondant.

La consigne de décalage est de préférence envoyée via le bus CAN 38 sur l'interface dédiée 33 du microcontrôleur 26. L'application reçoit une information sur 16bits comprise entre 0 et 360° correspondant à la variable φ' et applique un décalage réel φ compris entre -180° et 180°.

L'implémentation de la variante du procédé selon l'invention mettant en oeuvre le périphérique PWM 32 du microcontrôleur 26 est réalisée par la programmation sans difficulté particulière des algorithmes correspondants sur trois 39,40,41 des huit canaux PMW disponibles.

Le procédé et le dispositif décrits ci-dessus sont utilisés notamment pour la génération des signaux de commande d'une machine électrique polyphasée réversible, dite « alternateur-démarreur » pour véhicule automobile à moteur thermique.

Un autre domaine d'utilisation, où la diminution des temps de transit et de la gigue résultant du procédé et du dispositif selon l'invention constitue un avantage, est naturellement celui des allumages électroniques qui nécessitent la génération d'impulsions d'allumage en suivant une courbe de retard à l'allumage de manière d'autant plus précise que la montée en régime du moteur est rapide.

L'implémentation du procédé selon l'invention sur un type particulier de microcontrôleur 26, en se limitant à trois signaux Si1, Si2, Si3, n'est donnée qu'à titre d'exemple. L'homme de métier portera sans difficultés les algorithmes décrits sur d'autres composants programmables tels que des microprocesseurs associés à des mémoires, ou des FPGA (FPGA est l'acronyme anglais de « Field Programmable Gate Array » c'est-à-dire de « Réseau de Portes Programmables Prédiffusé ») pour un nombre quelconque de phases.

Comme il va de soi, l'invention ne se limite pas aux seuls modes d'exécution préférentiels décrits ci-dessus. Elle embrasse au contraire toutes les variantes possibles de réalisation dans la limite de l'objet des revendications ci-après.

## Revendications

1. Procédé de génération de signaux binaires déphasés (So1,So2,So3) d'un angle de déphasage de contrôle ($\varphi$) continûment variable par rapport à au moins un signal binaire de synchronisation d'un ensemble de signaux binaires de synchronisation (Si1,Si2,Si3) ayant une même période ($\Delta$Ttotal) variable, du type de ceux consistant à élaborer les fronts montants (8) et descendants (12) desdits signaux déphasés (So1,So2,So3) en calculant au moins un délai de commutation de niveau ($\Delta$T1) à partir de fronts de synchronisation, montants (2,3,5,6) ou descendants (1,4,7), dudit signal binaire de synchronisation (Si1,Si2,Si3) au moins, en fonction au moins dudit angle de déphasage de contrôle ($\varphi$), **caractérisé en ce qu'**au moins un front de référence (4,5,7) est choisi parmi lesdits fronts de synchronisation (1-7) tel que ledit délai ($\Delta$T1) est minimum.

2. Procédé de génération de signaux binaires déphasés (So1,So2,So3) selon la revendication 1, **caractérisé en ce que** le nombre desdits signaux déphasés (So1,So2,So3) et le nombre desdits signaux de synchronisation (Si1,Si2,Si3) étant égaux à un nombre de phases prédéterminé, et lesdits signaux de synchronisation (Si1,Si2,Si3) ayant un rapport cyclique égal à 0,5 et étant déphasés entre eux d'un angle de déphasage nominal ($\Phi$) en degrés égal à 360° divisé par ledit nombre de phases, on mesure un intervalle de temps ($\Delta$Tpn) compris entre deux desdits fronts de synchronisation (1-7) successifs, l'un étant montant et l'autre descendant.

3. Procédé de génération de signaux binaires déphasés (So1,So2,So3) selon la revendication 2, **caractérisé en ce que** ledit délai ($\Delta$1T) est calculé pour un signal binaire de synchronisation courant (Si1) parmi lesdits signaux binaires de synchronisation (Si1,Si2,Si3) en vue d'élaborer le front (8,12) correspondant du signal binaire déphasé courant (So1) associé par l'expression suivante :

$$\Delta T1 = \Delta Tpn \ * \ (\Delta\varphi ref - \varphi + 180) \ * \ Np/360$$

.

où :

- $\Delta$Tpn est ledit intervalle de temps ;
- $\varphi$ est ledit angle de phase de contrôle compris entre -180° et +180 ;
- $\Delta\varphi$ref est le déphasage $\varphi$0 - $\varphi$r, exprimé en degrés, entre un front initial (5) d'angle de phase initial $\varphi$0 dudit signal binaire de synchronisation courant (Si1) et ledit front de référence (4,5,7) d'angle de phase de référence $\varphi$r d'un signal binaire de synchronisation de référence choisi parmi lesdits signaux de synchronisation (Si1,Si2,Si3) ;
- Np est égal au double dudit nombre de phases.

4. Procédé de génération de signaux binaires déphasés (So1,So2,So3) selon la revendication 2, **caractérisé en ce qu'**une valeur interfront (V$\Delta$Tpn) dudit intervalle de temps ($\Delta$Tpn) résulte d'un comptage au moyen d'un circuit retardateur programmable de mesure (TIMERM, 34) associé auxdits signaux binaires de synchronisation (Sil, Si2,Si3) ayant une fréquence d'incrémentation de mesure (FTIMERM) prédéterminée.

5. Procédé de génération de signaux binaires déphasés (So1,So2,So3) selon la revendication 4, **caractérisé en ce qu'**une valeur courante (V$\Delta$T1) dudit délai ($\Delta$T1) est calculée pour un signal binaire de synchronisation courant (Si1) parmi lesdits signaux binaires de synchronisation (Si1,Si2,Si3) en vue d'élaborer le front correspondant (8,12) du signal binaire déphasé courant (So1) associé par l'expression suivante :

$$V\Delta T1=V\Delta Tpn * (\Delta\varphi ref-\varphi+180) * Np/360$$

où :

- V$\Delta$Tpn est ladite valeur interfront ;
- $\varphi$ est ledit angle de phase de contrôle compris entre -180° et +180 ;
- $\Delta\varphi$ref est le déphasage $\varphi$0 - $\varphi$r, exprimé en degrés, entre un front initial (5) d'angle de phase initial $\varphi$0 dudit signal binaire de synchronisation courant (Si1) et ledit front de référence (4,5,7) d'angle de phase de référence $\varphi$r d'un signal binaire de synchronisation de référence choisi parmi lesdits signaux binaires de synchronisation (Si1,Si2,Si3) ;
- Np est égal au double dudit nombre de phases.

6. Procédé de génération de signaux binaires déphasés (So1,So2,So3) selon la revendication 5, **caractérisé en ce qu'**il comprend les étapes suivantes :

- on rend la fréquence d'incrémentation courante (FTIMER1) d'un circuit retardateur programmable courant (TIMER1,35,36,37) associé audit signal binaire de synchronisation courant (Si1) égale à ladite fréquence d'incrémentation de mesure (FTIMERM) ;
- on associe une ligne de sortie courante (OUTPIN1) audit circuit retardateur programmable courant (TIMER1,35,36,37) ;
- on charge la valeur courante (V$\Delta$T1) dudit délai ($\Delta$T1) dans ledit circuit retardateur programmable courant (TIMER1,35,36,37);
- on configure ledit circuit retardateur programmable courant (TIMER1,35,36,37) de manière que ladite ligne de sortie courante (OUTPIN1) effectue une première transition d'un niveau haut vers un niveau bas, ou bien une seconde transition d'un niveau bas vers un niveau haut, quand un compteur courant dudit retardateur programmable courant (TIMER1,35,36,37) atteint ladite valeur courante (V$\Delta$T1) ;
- on génère ledit signal binaire déphasé courant (So1) au moyen de ladite ligne de sortie courante (OUTPIN1).

7. Procédé de génération de signaux binaires déphasés (So1,So2,So3) selon la revendication 5, **caractérisé en ce qu'**il comprend les étapes suivantes :

- on rend la fréquence d'incrémentation courante (FTIMER1) d'un circuit retardateur programmable courant (TIMER1,35,36,37) associé audit signal binaire de synchronisation courant (Si1) égale à ladite fréquence d'incrémentation de mesure (FTIMERM) ;
- on charge la valeur courante (V$\Delta$T1) dudit délai ($\Delta$T1) dans ledit circuit retardateur programmable courant (TIMER1,35,36,37) ;
- on active une interruption courante (INTT1) associée audit circuit retardateur programmable courant (TIMER1,35,36,37) se produisant à chaque fois que ladite valeur courante (V$\Delta$T1) est atteinte ;
- on rend la fréquence de comptage courante (FPMW) d'un compteur programmable courant (TIMERPWM1) d'un module de modulation de largeur d'impulsions programmable courant (PWM1,39,40,41) égale à ladite fréquence d'incrémentation de mesure (FTIMERM) divisée par le double dudit nombre de phases ;
- on associe une ligne de sortie courante (Spwm1) audit module de modulation de largeur d'impulsions programmable courant (PWM1,39,40,41) ;
- on charge un registre de période courant (REGPERpwm1) et un registre de rapport cyclique courant (REGDUTYpwm1) dudit module de modulation de largeur d'impulsions programmable courant (PWM1,39,40,41) respectivement avec ladite valeur interfront (V$\Delta$Tpn) et avec la moitié de ladite valeur interfront (V$\Delta$Tpn) ;
- on configure ledit module de modulation de largeur d'impulsions courant (PWM1,39,40,41) de façon que ladite ligne de sortie courante (Spwm1) subisse une transition initiale d'un niveau haut à un niveau bas, puis une première transition d'un niveau bas à un niveau haut quand ledit compteur programmable courant (TIMERPWM1) atteint une valeur intermédiaire courante (VDUTYpmw1) contenue dans registre de rapport cyclique courant (REGDUTYpwm1), et enfin une seconde transition d'un niveau haut à un niveau bas quand ledit compteur programmable courant (TIMERPWM1) atteint une valeur finale courante (VPERpwm1) contenue dans ledit registre de période courant (REGPERpwm1) à chaque déclenchement de ladite interruption courante (INTT1) ;
- on génère ledit signal binaire déphasé courant (So1) au moyen de ladite ligne de sortie courante (Spwm1).

**8.** Dispositif de génération de signaux binaires déphasés (So1,So2,So3) d'un angle de déphasage de contrôle (φ) continûment variable par rapport à au moins un signal binaire de synchronisation d'un ensemble de signaux binaires de synchronisation (Si1,Si2,Si3), du type de ceux comportant un microprocesseur ou un microcontrôleur (26) comprenant :

- au moins une unité centrale de traitement (27) ;
- au moins une mémoire volatile (29) et/ou au moins une mémoire non-volatile (28) ;
- au moins un circuit retardateur programmable (34,35,36,37);
- au moins un port d'entrée (30);
**caractérisé en que** lesdites mémoires (28,28) contiennent un programme mettant en oeuvre le procédé selon l'une quelconque des revendications 1 à 7 précédentes.

**9.** Dispositif de génération de signaux binaires déphasés (So1,So2,So3) selon la revendication 8, **caractérisé en ce qu'**il comporte de plus au moins un module de modulation de largeur d'impulsons programmable (39,40,41).

**10.** Dispositif de génération de signaux binaires déphasés (So1,So2,So3) selon l'une quelconque des revendications 8 ou 9, **caractérisé en ce qu'**il comporte de plus une interface série (33) recevant un signal représentatif dudit angle de phase de contrôle (φ), ladite interface (33) assurant de préférence une liaison avec un réseau embarqué (38) de type CAN.

**11.** Utilisation du procédé selon l'une quelconque des revendications 1 à 7 précédentes et/ou du dispositif selon l'une quelconque des revendications 8 à 10 dans la boucle de contrôle d'une machine électrique polyphasée embarquée sur un véhicule, notamment automobile.

**12.** Séquences d'instructions exécutables par le dispositif selon l'une quelconque des revendications 8 à 10 mettant en oeuvre le procédé selon l'une quelconque des revendications 1 à 7.

**Claims**

**1.** Method of generating binary signals (So1, So2, So3) out-of-phase by a control phase-difference angle (φ) continuously variable with a respect to at least one synchronisation binary signal of a set of synchronisation binary signals (Si1, Si2, Si3) having the same variable period (ΔTtotal), of the type consisting of producing the rising (8) and falling (12) edges of the said out-of-phase signals (So1, So2, So3) by calculating at least a level-switching delay (ΔT1) from synchronisation edges, rising (2, 3, 5, 6) or falling (1, 4, 7), of the said synchronisation binary signal (Si1, Si2, Si3) at least, according to at least the said control phase-difference angle (φ), **characterised in that** at least one reference edge (4, 5, 7) is chosen from the said synchronisation edges (1-7) such that the said delay (ΔT1) is minimum.

**2.** Method of generating out-of-phase binary signals (So1, So2, So3) according to claim 1, **characterised in that**, the number of the said out-of-phase signals (So1, So2, So3) and the number of the said synchronisation signals (Si1, Si2, Si3) being equal to a predetermined number of phases, and the said synchronisation signals (Si1, Si2, Si3) having a duty cycle ratio equal to 0.5 and being out-of-phase with each other by a nominal phase-difference angle (φ) in degrees equal to 360° divided by the said number of phases, an interval of time (ΔTpn) between two of the said successive synchronisation edges (1-7), one being rising and the other falling, is measured.

**3.** Method of generating out-of-phase binary signals (So1, So2, So3) according to claim 2, **characterised in that** the said delay (ΔT1) is calculated for a current synchronisation binary signal (Si1, Si2, Si3) among the said synchronisation binary signals (Si1, Si2, Si3) with a view to producing the corresponding edge (8, 12) of the associated current out-of-phase binary signal (So1) by the following expression:

$$\Delta T1 = \Delta Tpn * (\Delta\varphi ref - \varphi + 180) * Np/360$$

where:

- $\Delta Tpn$ is the said interval of time;
- $\varphi$ is the said control phase angle between -180° and +180°;
- $\Delta\varphi ref$ is the phase difference $\varphi 0 - \varphi r$, expressed in degrees, between an initial edge of initial phase angle $\varphi 0$ of the said current synchronisation binary signal and the said reference edge (4, 5, 7) of reference phase angle $\varphi r$ of a reference synchronisation binary signal chosen from the synchronisation signals (Si1, Si2, Si3):
- Np is equal to twice the number of phases.

4. Method of generating out-of-phase binary signals (So1, So2, So3) according to claim 2, **characterised in that** an inter-edge value ($V\Delta Tpn$) of the said interval of time ($\Delta Tpn$) results from a counting by means of a programmable measuring delay circuit (TIMERM, 34) associated with the said synchronisation binary signals (Si1, Si2, Si3) having a predetermined measurement incrementation frequency (FTIMERM).

5. Method of generating out-of-phase binary signals (So1, So2, So3) according to claim 4, **characterised in that** a current value ($V\Delta T1$) of the said delay ($\Delta T1$) is calculated for a current synchronisation binary signal (Si1) among the said synchronisation binary signals (Si1, Si2, Si3) with a view to producing the corresponding edge (8, 12) of the associated current out-of-phase binary signal (So1) by the following expression:

$$V\Delta T1 - V\Delta Tpn * (\Delta\varphi ref - \varphi + 180) * Np/360$$

where:

- $V\Delta Tpn$ is the said inter-edge value;
- $\varphi$ is the said control phase angle between -180° and +180°;
- $\Delta\varphi ref$ is the phase difference $\varphi 0 - \varphi r$, expressed in degrees, between an initial edge (5) of initial phase angle $\varphi 0$ of the said current binary synchronisation signal (Si1) and the said reference edge (4, 5, 7) of reference phase angle $\varphi r$ of a reference binary synchronisation signal chosen from the said binary synchronisation signals (Si1, Si2, Si3);
- Np is equal to twice the said number of phases.

6. Method of generating out-of-phase binary signals (So1, So2, So3) according to claim 5, **characterised in that** it comprises the following steps:

- the current incrementation frequency (FTIMER1) of a current programmable delay circuit (TIMER1, 35, 36, 37) associated with the said current binary synchronisation signal (Si1) is made equal to the said measurement incrementation frequency (FTIMERM);
- a current output line (OUTPIN1) is associated with the said current programmable delay circuit (TIMER1, 35, 36, 37);
- the current value ($V\Delta T1$) of the said delay ($\Delta T1$) is loaded into the said current programmable delay circuit (TIMER1, 35, 36, 37);
- the said current programmable delay circuit (TIMER1, 35, 36, 37) is configured so that the said current output line (OUTPIN1) makes a first transition from a high level to a low level, or a second transition from a low level to a high level, when a current counter of the said current programmable delay circuit (TIMER1, 35, 36, 37) reaches the said current value ($V\Delta T1$);
- the said current out-of-phase binary signal (So1) is generated by means of the current output line (OUTPINI).

7. Method of generating out-of-phase binary signals (So1, So2, So3) according to claim 5, **characterised in that** it comprises the following steps:

- the current incrementation frequency (FTIMER1) of a current programmable delay circuit (TIMER1, 35, 36, 37) associated with the said current binary synchronisation signal (Si1) is made equal to the said measurement incrementation frequency (FTIMERM);
- the current value (V$\Delta$T1) of the said switching delay ($\Delta$T1) is loaded into the current programmable delay circuit (TIMER1, 35, 36, 37);
- a current interruption (INTT1) associated with the said current programmable delay circuit (TIMER1, 35, 36, 37) is activated, occurring on each occasion that the said current value (V$\Delta$T1) is reached;
- the current counting frequency (FPMW) of a current programmable counter (TIMERPWM1) of a current programmable pulse width modulation module (PWM1, 39, 40, 41) is made equal to the measurement incrementation frequency (FTIMERM) divided by twice the number of phases;
- a current output line (Spwm1) is associated with the said current programmable pulse width modulation module (PWM1, 39, 40, 41);
- a current period register (REGPERpwm1) and a current duty cycle register (REGDUTYpwm1) of the said current programmable pulse width modulation module (PWM1, 39, 40, 41) are loaded respectively with the said inter-edge value (V$\Delta$Tpm) and with half the said inter-edge value (V$\Delta$Tpm);
- the said current programmable pulse width modulation module (PWM1, 39, 40, 41) is configured so that the said current output line (Spwm1) undergoes an initial transition from a high level to a low level and then a first transition from a low level to a high level when the said current programmable counter (TIMERPWM1) reaches a current intermediate value (VDUTYpmw1) contained in the current duty cycle register (REGDUTYpwm1), and finally a second transition from a high level to a low level when the said current programmable counter (TIMERPWM1) reaches a current final value (VPERpwm1) contained in the said current period register (REGPERpwm1) at each triggering of the said current interruption (INIT1);
- the said current out-of-phase binary signal (So1) is generated by means of the current output line (Spwm1).

8. Device for generating binary signals (So1, So2, So3) out of phase by a control phase-difference angle ($\varphi$) continuously variable with respect to at least one binary synchronisation signal in a set of binary synchronisation signals (Si1, Si2, Si3), of the type comprising a microprocessor (26) or a microcontroller comprising:

- at least one central processing unit (27);
- at least one volatile memory (29) and/or at least one non-volatile memory (28);
- at least one programmable delay circuit (34, 35, 36, 37);
- at least one input port (3);
**characterised in that** the said memories (28, 28) contain a program implementing the method according to any one of the preceding claims 1 to 7.

9. Device for generating out-of-phase binary signals (So1, So2, So3) according to claim 8, **characterised in that** it also comprises at least one programmable pulse width modulation module (39, 40, 41).

10. Device for generating out-of-phase binary signals (So1, So2, So3) according to either one of claims 8 or 9, **characterised** that it also comprises a serial interface (33) receiving a signal representing the said control phase angle ($\varphi$), the said interface (33) preferably providing a connection with an onboard network (38) of the CAN type.

11. Use of the method according to any one of the preceding claims 1 to 7 and/or of the device according to any one of claims 8 to 10 in the control loop of a polyphase electrical machine installed on a vehicle, in particular a motor car.

12. Sequences of instructions able to be executed by the device according to any one of claims 8 to 10 implementing the method according to any one of claims 1 to 7.

**Patentansprüche**

1. Verfahren zur Erzeugung von Außer-Phase-Binärsignalen (So1, So2, So3) mit einem Steuerphasenverschiebungswinke ($\varphi$), der im Verhältnis zu mindestens einem binären Synchronisationssignal aus einer von binären Synchronisationssignalen (Si1, Si2, Si3) mit einer gleichen variablen Laufzeit ($\Delta$Ttotal) ständig veränderlich ist, von der Art, die darin besteht, dass die Anstiegsflanken (8) und die Abfallflanken (12) der besagten Außer-Phase-Signale (So1, So2, So3) durch Berechnung von mindestens einer Pegelumschaltzeit (ΔT1) anhand von ansteigenden Flanken (2, 3, 5, 6) oder abfallenden Flanken (1, 4, 7) der Synchronisation mindestens des besagten binären Synchronisationssignals (Si1, S12, Si3) und mindestens in Abhängigkeit von dem besagten Steuerphasenverschiebungswinkel (φ) generiert werden, **dadurch gekennzeichnet, dass** mindestens eine Referenzflanke (4, 5, 7) aus den Flanken der Synchronisation (1 - 7) so ausgewählt wird, die besagte Umschaltzeit (ΔT1) minimal ist.

2. Verfahren zur Erzeugung von Außer-Phase-Binärsignalen (So1, So2, So3) nach Anspruch 1, **dadurch gekennzeichnet, dass** die Anzahl der Außer-Phase-Signale (So1, So2, So3) und die Anzahl der besagten Synchronisationssignale (Si1, Si2, Si3) gleich einer bestimmten Phasenzahl ist, dass die besagten Synchronisationssignale (Si1, Si2, Si3) ein Tastverhältnis von 0,5 haben und untereinander um einen Nennphasenverschiebungswinkel (Φ) in Grad von 360° geteilt durch die besagte Phasenzahl verschoben sind, und dass ein Zeitintervall (ΔTpn) zwischen zwei der besagten aufeinander folgenden Flanken der Synchronisation (1 - 7) gemessen wird, von denen eine ansteigend und die andere abfallend ist.

3. Verfahren zur Erzeugung von Außer-Phase-Binärsignalen (So1, So2, So3) nach Anspruch 2, **dadurch gekennzeichnet, dass** die besagte Umschaltzeit (ΔT1) für ein aktuell aus den besagten Synchronisationssignalen (Si1, Si2, Sei3) ausgewähltes binäres Synchronisationssignal (Si1) berechnet wird, um die entsprechende Flanke (8, 12) des aktuell ausgewählten zugeordneten Außer-Phase-Binärsignals (So1) zu generieren, mit der Formel:

$$\Delta T1 = \Delta Tpn * (\Delta\varphi ref - \varphi + 180) * Np/360$$

worin

- ΔTpn das besagte Zeitintervall ist,
- φ der besagte Steuerphasenwinkel zwischen -180° und +180 ist,
- Δφref die Phasenverschiebung φ0 - φr ist, ausgedrückt in Grad, zwischen einer Anfangsflanke (5) des Anfangsphasenwinkels φ0 des besagten aktuell ausgewählten binären Synchronisationssignals (Si1) und der besagten Referenzflanke (4, 5, 7) des Referenzphasenwinkels φr eines aus den besagten Synchronisationssignalen (Si1, Si2, Si3) ausgewählten binären Referenzsynchronisationssignals;
- Np gleich das Doppelte der besagten Phasenzahl ist,

4. Verfahren zur Erzeugung von Außer-Phase-Binärsignalen (So1, So2, So3) nach Anspruch 2, **dadurch gekennzeichnet, dass** sich ein Wert zwischen Flanken (VΔTpn) des besagten Zeitintervalls (ΔTpn) aus einer Zählung mit einer programmierbaren Verzögerungsmessschaltung (TIMERM, 34) ergibt, die den besagten Synchronisationssignalen (Si1, Si2, Si3) zugeordnet ist und eine vorgegebene Messinkrementierungsfrequenz (FTIMERM) hat.

5. Verfahren zur Erzeugung von Außer-Phase-Binärsignalen (So1, So2, So3) nach Anspruch 4, **dadurch gekennzeichnet, dass** ein aktuell ausgewählter Wert (VΔT1) der besagten Umschaltzeit (ΔT1) für ein aktuell aus den besagten Synchronisationssignalen (Si1, Si2, Si3) ausgewähltes binäres Synchronisationssignal (Si1) berechnet wird, um die entsprechende Flanke (8, 12) des aktuell ausgewählten zugeordneten Außer-Phase-Binärsignals (So1) zu generieren, mit der Formel:

$$V\Delta T1 = V\Delta Tpn * (\Delta\varphi ref - \varphi + 180) * Np/360$$

worin

- VΔTpn der besagte Wert zwischen Flanken ist,
- φ der besagte Steuerphasenwinkel zwischen -180° und +180 ist,
- Δφref die Phasenverschiebung φ0 - φr ist, ausgedrückt in Grad, zwischen einer Anfangsflanke (5) des Anfangsphasenwinkels $\varphi_0$ des besagten aktuell ausgewählten binären Synchronisationssignals (Si1) und der besagten Referenzflanke (4, 5, 7) des Referenzphasenwinkels φr eines aus den besagten Synchronisationssignalen (Si1, Si2, Si3) ausgewählten binären Referenzsynchronisationssignals,
- Np gleich das Doppelte der Phasenzahl ist.

6. Verfahren zur Erzeugung von Außer-Phase-Binärsignalen (So1, So2, So3) nach Anspruch 5, **dadurch gekennzeichnet, dass** es die folgenden Schritte umfasst,

- die aktuell ausgewählte Inkrementierungsfrequenz (FTIMER1) einer aktuell ausgewählten programmierbaren Verzögerungsschaltung (TIMER1, 35, 36, 37), die dem besagten aktuell ausgewählten binären Synchronisationssignal (Si1) zugeordnet ist, wird der besagten Messinkrementierungsfrequenz (FTIMERM) gleichgesetzt;
- eine aktuell ausgewählte Ausgangsleitung (OUTPIN1) wird der besagten aktuell ausgewählten programmierbaren Verzögerungsschaltung (TIMER1, 35, 36, 37) zugeordnet,
- der aktuell ausgewählte Wert (V$\Delta$T1) der besagten Umschaltzeit ($\Delta$T1) wird in die besagte aktuell ausgewählte programmierbare Verzögerungsschaltung (TIMER1, 35, 36, 37) geladen,
- die besagte aktuell ausgewählte programmierbare Verzögerungsschaltung (TIMER1, 35, 36, 37) wird so konfiguriert, dass die besagte aktuell ausgewählte Ausgangsleitung (OUTPIN1) einen ersten Übergang von einem oberen zu einem unteren Signalpegel oder auch einen zweiten von einem unteren zu einem oberen Signalpegel ausführt, wenn ein ausgewählter Zähler der besagten aktuell ausgewählten programmierbaren Verzögerungsschaltung (TIMER1, 35, 36, 37) den besagten aktuell ausgewählten Wert (V$\Delta$T1) erreicht,
- das besagte aktuell ausgewählte Außer-Phase-Binärsignat (So1) wird mittels der besagten aktuell ausgewählten Ausgangsleitung (OUTPIN1) erzeugt.

7. Verfahren zur Erzeugung von Außer-Phase-Binärsignalen (So1, So2, So3) nach Anspruch 5, **dadurch gekennzeichnet, dass** es die folgenden Schritte umfasst:

- die aktuell ausgewählte Inkrementierurigsfrequenz (FTIMER1) einer aktuell ausgewählten programmierbaren Verzögerungsschaltung (TIMER1, 35, 36, 37), die dem besagten aktuell ausgewählten binären Synchronisationssignal (Si1) zugeordnet ist, wird der besagten Messinkrementierungsfrequenz (FTIMERM) gleichgesetzt,
- der aktuell ausgewählte Wert (V$\Delta$T1) der besagten Umschaltzeit ($\Delta$T1) wird in die besagte aktuell ausgewählte programmierbare Verzögerungsschaltung (TIMER1, 35, 36, 37) geladen,
- es wird eine aktuell ausgewählte Unterbrechung (INTT1) aktiviert, die der besagten aktuell ausgewählten programmierbaren Verzögerungsschaltung (TIMER1, 35, 36, 37) zugeordnet ist und jedes Mal erfolgt, der besagte aktuell ausgewählte Wert (VAT1) erreicht ist,
- die aktuell ausgewählte Zählfrequenz (FPMW) eines aktuell ausgewählten programmierbaren Zählers (TIMERPWM1) eines aktuell ausgewählten programmierbaren Impulsbreitenmodulationsmoduls (PWM1, 39, 40, 41) wird der besagten Messinkrementierungsfrequenz (FTIMERM) geteilt durch das Doppelte der besagten Phasenzahl gleichgesetzt,
- eine aktuell ausgewählte Ausgangsleitung (Spwm1) wird dem besagten aktuell ausgewählten programmierbaren Impulsbreitenmodulationsmodul (PWM1, 39, 40, 41) zugeordnet,
- ein aktuell ausgewähltes Periodenregister (REGPERpwm1) und ein aktuell ausgewähltes Tastverhältnisregister (REGDUTYpwm1) des besagten aktuell ausgewählten programmierbaren Impulsbreitenmodulationsmoduls (PWM1, 39, 40, 41) werden mit dem besagten Wert zwischen Flanken (V$\Delta$Tpn) beziehungsweise mit der Hälfte des besagten Werts zwischen Flanken (V$\Delta$Tpn) geladen,
- das besagte aktuell ausgewählte programmierbare Impulsbreitenmodulationsmodul (PWM1, 39, 40, 41) wird so konfiguriert, dass in der besagten aktuell ausgewählten Ausgangsleitung (Spwm1), bei jeder Auslösung der besagten aktuell ausgewählten Unterbrechung (INTT1), ein Anfangsübergang von einem oberen zu einem unteren und ein erster Übergang von einem unteren zu einem oberen Pegel erfolgt, der besagte aktuell ausgewählte programmierbare Zähler (TIMERPWM1) einen aktuell ausgewählten Zwischenwert (VDUTYpmw1) erreicht, der in dem aktuell ausgewählten Tastverhältnisregister (REGDUTYpm1) enthalten ist, und anschließend ein zweiter von einem oberen zu einem unteren Pegel, wenn der besagte aktuell ausgewählte programmierbare Zähler (TIMERPWM1) einen aktuell ausgewählten Endwert (VPERpwm1) der in dem besagten aktuell ausgewählten Periodenregister (REGPERpwm1) enthalten ist,
- das besagte aktuell ausgewählte Außer-Phase-Binärsignal (So1) wird mittels der besagten aktuell ausgewählten Ausgangsleitung (Spwm1) erzeugt.

8. Vorrichtung zur Erzeugung von Außer-Phase-Binärsignalen (So1, So2, So3) mit einem Steuerphasenverschiebungswinkel ($\varphi$), der im Verhältnis zu mindestens einem binären aus einer Gruppe von binären Synchronisationssignalen (Si1, Si2, Si3) ständig veränderlich ist, von der Art mit einem Mikroprozessor oder einem Mikrocontroller (26), die

- mindestens eine zentrale Verarbeitungseinheit (27),
- mindestens einen flüchtigen Speicher (29) und/oder mindestens einen nichtflüchtigen Speicher (28),

- mindestens eine programmierbare Verzögerungsschaltung (34, 35, 36, 37),
- mindestens einen Eingangsport (30)

umfasst, **dadurch gekennzeichnet, dass** die besagten Speicher (28, 28) ein Programm beinhalten, das das Verfahren nach einem der vorhergehenden Ansprüche 1 bis 7 anwendet.

9. Vorrichtung zur von Außer-Phase-Binärsignalen (So1, So2, So3) nach Anspruch 8, **dadurch gekennzeichnet, dass** es außerdem mindestens ein programmierbares Impulsbreitenmodulationsmodul (39, 40, 41) umfasst.

10. zur Erzeugung von Außer-Phase-Binärsignalen (So1, So2, So3) nach Anspruch 8 oder 9, **dadurch gekennzeichnet, dass** es außerdem eine serielle Schnittstelle (33) die ein Signal das für den besagten Steuerphasenwinkel ($\varphi$) repräsentativ ist, wobei die besagte Schnittstelle (33) vorzugsweise eine Verbindung mit einem Bordnetz (38) des Typs CAN sicherstellt.

11. Anwendung des Verfahrens nach einem der vorhergehenden Ansprüche 1 bis 7 und/oder der Vorrichtung nach einem der Ansprüche 8 bis 10 in der Steuerschleife einer mehrphasigen elektrischen Maschine in einem Fahrzeug, in in einem Automobil.

12. Befehlsfolgen, die von der Vorrichtung nach einem der Ansprüche 8 bis 10 mit dem Verfahren nach einem der Ansprüche 1 bis 7 ausgeführt werden können.

FIG. 1

FIG. 2

EP 2 022 171 B1

FIG. 3a

FIG. 3b

FIG. 3c

FIG. 4

FIG. 5

FIG. 6

**FIG. 7**

**FIG. 8**

FIG. 9

Si1  Si2  Si3  VΔT1$_n$  TIMER1  TIMERpwm1  Spwm1 =So1

23  24  25

$\varphi'$  $\varphi_0$  $t_n$  $\Delta T_{pn}$  $\Delta T1_n$  T

25

FIG. 10

FIG. 11

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6744296 B
- DE 4128909 A1
- US 4788957 A
- US 5317248 A